**Europäisches Patentamt**

**European Patent Office**

**Office européen des brevets**

(19)

(11) Veröffentlichungsnummer: **0 003 755**
**B1**

(12) **EUROPÄISCHE PATENTSCHRIFT**

(45) Veröffentlichungstag der Patentschrift: **13.04.83**

(21) Anmeldenummer: **79100251.2**

(22) Anmeldetag: **29.01.79**

(51) Int. Cl.³: **H 04 L 25/20, H 03 K 5/01**

(54) **Schaltungsanordnung zum Empfang von Einfachstrom- und Doppelstrom-Telegrafiezeichen.**

(30) Priorität: **17.02.78 DE 2806884**

(43) Veröffentlichungstag der Anmeldung:
**05.09.79 Patentblatt 79/18**

(45) Bekanntmachung des Hinweises auf die Patenterteilung:
**13.04.83 Patentblatt 83/15**

(84) Benannte Vertragsstaaten:
**BE DE FR GB IT NL**

(56) Entgegenhaltungen:
**DE - A - 2 038 735**
**DE - B - 2 423 463**
**US - A - 2 430 547**
**US - A - 3 999 085**

**ELECTRICAL DESIGN NEWS, Vol. 18, Nr. 21, 5. November 1973. Denver, A. S. Bozorth: "Pulse verification Yields Good Noise Immunity", Seiten 75, 76**
**NEUES AUS DER TECHNIK, Nr, 4, 1. Juli 1969, Würzburg, "Telegraphieübertrager", Seite 4**

(73) Patentinhaber: **SIEMENS AKTIENGESELLSCHAFT**
**Berlin und München Wittelsbacherplatz 2**
**D-8000 München 2 (DE)**

(72) Erfinder: **Giersberg, Dieter**
**Kampenwandstraße 19**
**D-8152 Feldkirchen-Westerham 1 (DE)**

## Schaltungsanordnung zum Empfang von Einfachstrom- und Doppelstrom-Telegrafiezeichen

Die Erfindung bezieht sich auf eine Schaltungsanordnung zum Empfang von Einfachstrom- und Doppelstrom-Telegrafiezeichen mit ein Schwellwertverhalten aufweisenden Verstärkerelementen, die die an einem in einer Telegrafieleitung enthaltenen Widerstand abfallende Spannung bewerten.

Empfansschaltungen für Telegrafiezeichen bewerten üblicherweise den über eine Telegrafieleitung fließenden Strom mit Hilfe von Relais. Zu ihrem Betrieb sind Leitungsergänzungswiderstände und für den Betrieb in Einfachstromtelegrafiekreisen Nachbildungswiderstände erforderlich, deren Dimensionierung von den individuellen Eigenschaften der Telegrafiestromkreise abhängt. Änderungen der Leitungseigenschaften erfordern deshalb in der Regel eine Neueinstellung der Empfangsschaltung. Dies wir vor allem dann als Nachteil empfunden, wenn eine an eine Vielzahl von Telegrafieleitungen anschaltbare Empfangsschaltung benötigt wird. Ein Beispiel hierfür ist die Anschaltung einer Mitleseeinrichtung an Telegrafieleitungen. Derartige Einrichtungen finden in der Telegrafietechnik vor allem zur Überwachung von Teilnehmer- oder Amtsverbindungen Anwendung. Es ist somit Bereits bekannt, diese Einrichtungen mit einen hochohmiger Eingang zu versehen, denn ein in der Telegraphicleitung liegender · neiderohmiger Widerstand parallelgeschaltet ist, wobei jedoch Verzerrungen und Störimpulse auftreten Können.

Es ist nun bereits eine Störimpuls-Unterdrückungsschaltung bekannt (Zeitschrift "Electrical Design News", Vol. 18, Nr. 21, 5. Nov. 1973, Denver, Seiten 75, 76. A. S. Bozorth: "Pulse verification yields good noise immunity"), bei der gegebenenfalls Störimpulse enthaltende Signale zum einen über ein erstes Differenzierglied direkt und zum anderen in invertierter Form über ein zweites Differenzierglied den Eingängen eines NAND-Gliedes zugeführt werden, welches ein monostabiles Kippglied steuert, das ausgangsseitig über ein drittes Differenzierglied mit dem Takteingang eines bistabilen Kippgliedes verbunden ist. Dieses bistabile Kippglied erhält an seinen Signaleingängen das erwähnte Signal direkt bzw. invertiert zugeführt. Am Ausgang des betreffenden bistabilen Kippgliedes ist ein von Störimpulsen befreites Ausgangssignal abnehmbar.

Obwohl die vorstehend betrachtete Störimpuls-Unterdrückungsschaltung an sich eine wirksame Störimpulsunterdrückung mit sich bringt, würde eine versuchsweise Verwendung dieser bekannten Störimpuls-Unterdrückungsschaltung bei einer zum Empfang von Einfachstrom- und Doppelstrom-Telegrafiezeichen dienenden Schaltungsanordnung der eingangs genannten Art dann nicht zufriedenstellen können, wenn man berücksichtigt, daß die Telegrafiezeichen mit unterschiedlichen und schwankenden Spannungs- bzw. Strompegeln auftreten können. In einem solchen Fall kann es dann nämlich ohne weiteres vorkommen, daß die betreffende Schaltung fehlerhaft arbeitet.

Es ist nun auch schon eine Schaltungsanordnung zur galvanischen Trennung mit optoelektronischen Koppelelementen bekannt (DE—A 2 423 463), bei der über einen Eingang ein Eingangssignal einem ersten bzw. zweiten Schwellwertverstärker zugeführt wird, über deren Ausgang ein Ausgangssignal übertragen wird. Bei dieser bekannten Schaltungsanordnung werden Daten vom Eingang zum Ausgang übertragen. Den beiden einen Fensterdiskriminator bildenden Schwellwertverstärkern ist jeweils ein optoelektronischen Koppelelement nachgeschaltet, welches an seinem Ausgang erste bzw. zweite Signale abgibt, solange das Eingangssignal eine erste bzw. zweite Schwellenspannung über- bzw. unterschreitet. Ferner ist mit den Ausgängen der optoelektronischen Koppelelemente ein Flipflop verbunden, welches gesetzt bzw. rückgesetzt wird, wenn von einem der optoelektronisch Koppelelemente ein erstes bzw. zweites Signal abgegeben wird. Das betreffende Flipflop gibt sein Ausgangssignal über den erwähnten Ausgang ab.

Von Nachteil bei der zuletzt betrachteten bekannten Schaltungsanordnung ist, daß diese lediglich zum Empfang von Enfachstrom- und Doppelstrom-Telegrafiezeichen ausgelegt ist, welche über eine einzige Telegrafieleitung übertragen werden. Wenn nun der Wunsch besteht, über eine Mehrzahl von Telegrafieleitungen übertragene Einfachstrom- und Doppelstrom-Telegrafiezeichen empfangen zu können, so müßte die betrachtete bekannte Schaltungsanordnung in einer entsprechenden Mehrzahl vorgesehen sein. Dies würde jedoch einen sehr hohen schaltungstechnischen Aufwand mit sich bringen. Man könnte nun die in einer solchen Mehrzahl vorgesehenen Schaltungsanordnungen dadurch zu vereinfachen versuchen, daß man die einen Schwellwertverstärker der insgesamt vorgesehenen Fensterdiskriminatoren wegläßt. Dies würde jedoch zu einer höheren Störanfälligkeit der gesamten Schaltungsanordnung führen. Darüber hinaus könnte es durch Verkoppelungen zwischen den einzelnen Telegrafieleitungen über die Schwellwertverstärker und über die für diese vorgesehene Stromversorgung zu Betriebsstörungen kommen, und zwar insbesondere dadurch, daß Kurzschlüsse zwischen Telegrafieleitungen auftreten.

Der Erfindung liegt demgemäß die Aufgabe zugrunde, eine Schaltungsanordnung der eingangs genannten Art so weiterzubilden, daß diese sowohl mit relativ geringem schaltungstechnischen Aufwand als auch mit besonders hoher Betriebssicherheit, d.h. Störunanfälligkeit für in einer Mehrzahl vorhandene Telegrafieleitungen verwendet werden kann.

Gelöst wird die vorstehend aufgezeigte Aufgabe bei einer Schaltungsanordnung der eingangs genannten Art erfindungsgemäß dadurch, daß für in einer Mehrzahl vorgesehene Telegrafieleitungen, die hinsichtlich der Übertragung von Telegrafiezeichen entweder als Sendeleitung oder als Empfangsleitung ausgenutzt sind, zwei gesonderte Verstärkerelemente vorgesehen sind, die mit Signaleingängen jeweils über ein Differenzierglied an jeweils in einer Empfangsleitung bzw. in einer Sendeleitung liegenden Widerständen anschaltbar sind, daß die beiden Verstärkerelementemit ihren Stromversorgungsanschlüssen jeweils an einer eigenen, galvanisch von den Telegrafieleitungen getrennten Stromversorgung angeschlossen sind, daß die beiden Verstärkerelemente mit ihren Signalausgängen zum einen jeweils über ein Integrationsglied mit ihrem jeweiligen Signaleingang rückgekoppelt sind und zum anderen jeweils an einem Signaleingang einer ersten Differenzierschaltung angeschlossen sind, daß der ersten Differenzierschaltung eine monostabile Kippstufe nachgeschaltet ist, die ausgangsseitig über eine zweite Differenzierschaltung am Takteingang einer bistabilen Kippstufe angeschlossen ist, und daß die von ihrem Ausgang den jeweils empfangenen Telegrafiezeichen entsprechende Telegrafiezeichen abgebende bistabile Kippstufe mit ihren Datensignaleingängen an Schaltungspunkten angeschlossen ist, die den Ausgangssignalen der Verstärkerelemente entsprechend Signale führen.

Die Erfindung bringt den Vorteil mit sich, daß insgesamt mit einem relativ geringen schaltungstechnischen Aufwand Einfachstrom- und Doppelstrom - Telegrafiezeichen vor einer großen Anzahl von Telegrafieleitungen her bei einer relativ hohen Störanfälligkeit empfangen werden können. Dabei wird mit einem geringeren schaltungstechnischen Aufwand ausgekommen, als dies durch die möglichen Anwendungen der zuletzt betrachteten bekannten Schaltungsanordnung zu erwarten ist, wobei durch die Anwendung einer der eingangs betrachteten bekannten Störimpuls-Unterdrückungsschaltung entsprechenden Schaltung insgesamt bei geringem schaltungstechnischen Aufwand eine besonders geringe Störunanfälligkeit erzielt wird. Dieser Vorteil wird auch durch die Schaltungsmaßnahme gestützt, wonach die beiden Verstärkerelemente mit ihren Stromversorgungsanschlüssen jeweils an einer eigenen, galvanisch von den Telegrafieleitungen getrennten Stromversorgung angeschlossen sind. Dadurch ist es nämlich in vorteilhafter Weise möglich, diese Verstärkerelemente in besonders einfacher Art und Weise an die Telegrafieleitungen anschließen zu können, ohne daß damit irgendwelche Schwierigkeiten der oben betrachteten Art verbunden sind. Darüber hinaus bringt die Erfindung den wesentlichen Vorteil mit sich, daß sie bereits auf geringe Spannungsabfälle reagiert und deshalb an sehr niederohmige Widerstände in den Telegrafieleitung, z.B. an Meßwiderständen, anschließbar ist. Im übrigen ermöglicht es die Schaltungsanordnung gemäß der Erfindung nach erfolgter Anschaltung an die vorgesehenen Telegrafieleitungen, daß ohne weitere Bedienung ausgekommen werden kann. Schließlich gewährleistet es die Schaltungsanordnung gemäß der Erfindung, daß die durch Einschwingvorgänge verursachten Verzerrungen eliminiert sind.

Zweckmäßigerweise sind die Verstärkerelemente Operations-verstärker, die mit ihren invertierenden Eingängen der jeweiligen Telegrafieleitung anschaltbar sind. Dies bringt den Vorteil mit sich, daß mit besonders einfachen und störunanfälligen Verstärkerelementen gearbeitet werden kann.

Zweckmäßigerweise ist die Kippzeit der monostabile Kippstufe auf einen Wert einstellbar, der die Abgage eines Taktimpulses für die bistabile Kippstufe um eine solche Zeitdauer vorzögert, daß kurzzeitige Störimpulse am Eingang der Eingangsschaltung unberücksichtigt bleiben, d.h. daß die Empfangsschaltung gegenüber Störimpulsen am Eingang unempfindlich ist.

Durch die Verwendung von Optokopplern als Übertragungselemente zeischen der Verstärkerelementen und der ersten Differenzierschaltung wird auf relativ einfache Weise eine galvanische Trennung zwischen diesen Schaltungsteilen erreicht. In diesem Zusammenhang sei jedoch angemerkt, daß die Verwendung von Optokopplern zum Zwecke der galvanischen Trennung für sich bekannt ist (DE—A—2 423 463 und US—A—3 999 085).

Der Schaltungsanordnung gemäß der Erfindung können zweckmäßigerweise ein Steuerschaltmittel, vorzugsweise ein elektronisches Relais, und eine Verbindungsüberwachungsschaltung nachgeschaltet sein. Diese Anordnung arbeitet dann als Mitleseeinrichtung, über die eine Mitlesemaschine lediglich für die Dauer des Schreibzustandes anschaltbar ist. Die Einschaltung der Mitlesemaschine selbst kann über ein eingebautes Motorschaltrelais, durch das beispielsweise der Motor einer Fernschreibmaschine ein- und ausschaltbar ist, über einen mechanischen Fernschalter oder über ein an dem Ausgang der Mitleseeinrichtung angeschaltetes Fernschaltgerät erfolgen. Dies eröffnet die vorteilhafte Möglichkeit, die eigentliche Mitlesemaschine getrennt von der Mitleseeinrichtung anzuordnen. In diesem Falle ist die Mitlesemaschine mit de Mitleseeinrichtung über eine Leitung verbunden, auf der wahlweise mit Kurzschluß- mit Unterbrechungs- oder mit Doppelstromtastung gearbeitet werden kann und die entsprechend dem Schreib- oder Ruhezustand umgepolt wird.

Weitere Einzelheiten der Erfindung werden im folgenden anhand der in den Zeichnungen dargestellten Ausführungsbeispiele erläutert. Dabei zeigt.

Fig. 1 den Gesamtaufbau der Empfangsschaltung,

Fig. 2 ein Beispiel für die Eingangsschaltung der Empfangsschaltung,

Fig. 3 ein Beispiel für die Ausgangsschaltung der Empfangsschaltung,

Fig. 4 ein Beispiel für die Verbindungsüberwachungsschaltung mit den zum Einsatz als Mitleseeinrichtung erforderlichen Einzelheiten und

Fig. 5 ein auf einige ausgewählte Schaltungspunkte der in den Figuren 2, 3 und 4 dargestellten Schaltungen bezogenes Spannungs- und Impulsdiagramm.

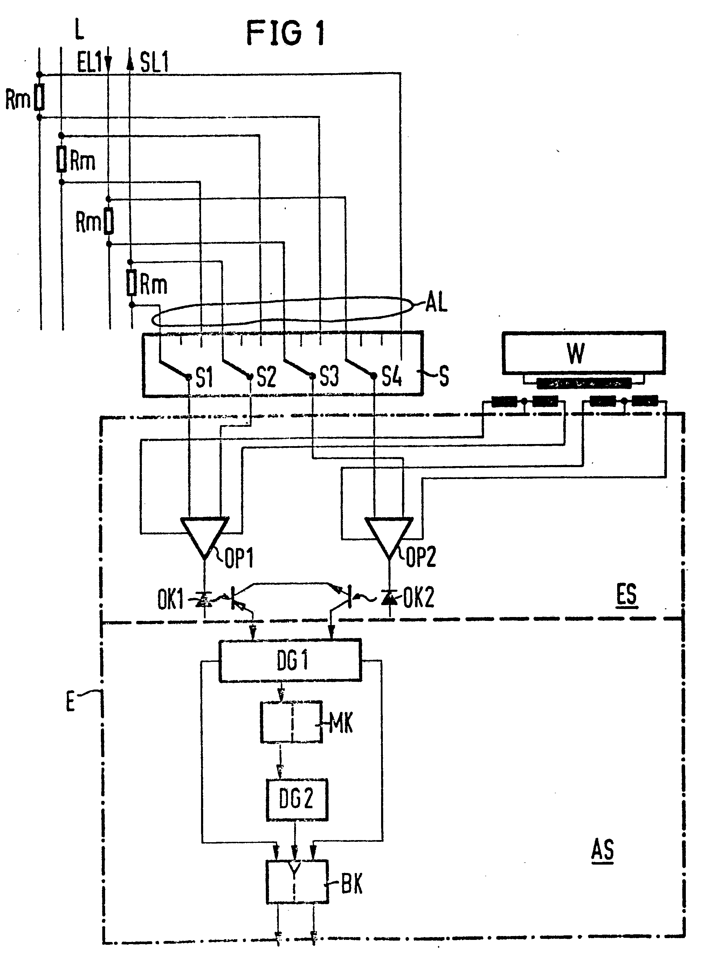

Aufbau und Wirkungsweise der erfindungsgemäßen Schaltungsanordnung werden im folgenden anhand von Fig. 1 beschrieben. Die dort dargestellte Empfangsschaltung E, die aus der Eingangsschaltung ES und der Ausgangsschaltung AS besteht, ist über eine Schalteinrichtung S, die im Beispiel vier Schaltarme S1 bis S4 enthält, an die Telegrafierleitungen L anschaltbar. Die Telegrafierleitungen L können dabei jeweils Teilnehmeranschlußleitungen oder Amtsverbindungsleitungen sein. Über die Schalteinrichtung S und eine im Beispiel 12-adrige Anschlußleitung AL ist die Empfangsschaltung E jeweils an eine Sende- und eine Empfangsleitung SL und EL in der Weise anschaltbar, daß den Eingängen der Eingangsschaltung ES eine Spannung zugeführt wird, die bei Fließen eines Leitungsstromes in der Sendeleitung SL und in der Empfangssleitung EL an dort angeordneten Widerständen abfällt. Im Beispiel dienen dazu die Meßwiderstände Rm in der Sendeleitung SL1 und in der Empfangsleitung EL1. Die an den Meßwiderständen Rm abfallende Spannung wird den in der Eingangsscheltung ES enthaltenen und jeweils für die Sende- und die Empfangsrichtung vorgesehenen Verstärkerelementen, im Beispiel den Operationsverstärkern OP1 und OP2, zugeführt, für die eine eigene galvanisch getrennte Stromversorgung W vorgesehen ist. Über den Ausgang jedes dieser Operationsverstärker OP1 und OP2 ist hier ein Übertragungselement, im Beispiel ein Optokoppler OK1 und OK2, vorgesehen. Abhängig von Stop- oder Startpolarität auf den Leitungen SL1 und EL1 werden die Ausgangstransistoren der Optokoppler OK1 und OK2 leitend oder gesperrt. Ein auf diese Weise von der Eingangsschaltung ES abgegebenes Signal wird in der ersten Differenzierschaltung DG1 der Ausgangsschaltung AS differenziert und als Triggerimpuls für eine monostabile Kippstufe MK ausgenutzt. Die Kippzeit der monostabilen Kippstufe MK ist einstellbar und entspricht im betrachteten Beispiel einer halben Schrittlänge der über die Telegrafierleitung SL1, EL1 übertragenen Zeichen. Über das der monostabilen Kippstufe MK nachgeschaltete Differenzierglied DG2 wird ein Triggerimpuls für eine bistabile Kippstufe BK stets dann gebildet, wenn die monostabile Kippstufe MK nach einer Umsteuerung in ihre Ausgangslage zurückkehrt. Dabei wird jeweils die einem stppolaren oder einem startpolaren Zeichenschritt entsprechende Information aus der ersten Differenzierschaltung DG1 in die bistabile Kippstufe BK übernommen. Damit wird erreicht, daß jeder Polaritätswechsel auf der in Sende- und Empfangsrichtung überwachten Telegrafierleitung im betrachteten Beispiel um eine halbe Schrittlänge verzögert vom Eingang der Empfangsschaltung E in die bistabile Kippstufe BK übernommen wird. Verzerrungen, die durch Einschwingvorgänge vor allem auf Einfachstromleitungen auftreten, werden dabei eliminiert. Die Anpassung der Anordnung auf verschiedene Telegrafiergeschwindigkeiten ist in einfacher Weise durch Veränderung der Kippzeit der monostabilen Kippstufe MK erreichbar.

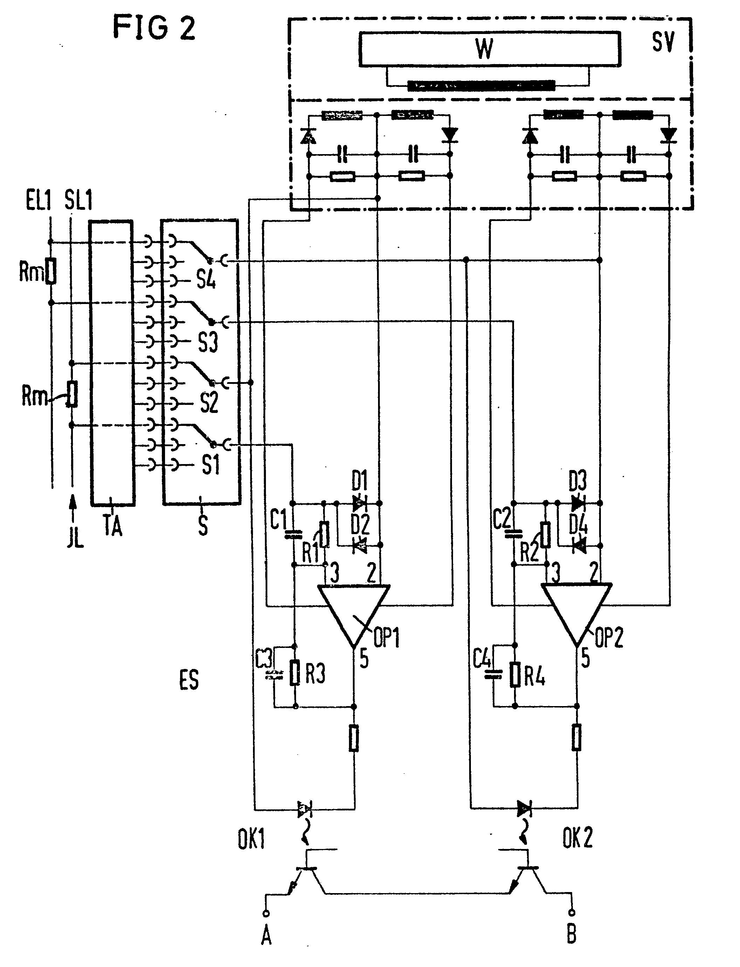

Den Aufbau der Eingangsschaltung ES und deren Anschaltung an eine Telegrafierleitung zeigt Fig. 2. Die anschaltung erfolgt über die bereits beschriebene Schalteinrichtung S mit den Schaltarmen S1 bis S4, die hier über eine Steckverbindung an die Prüfsteckerleiste TA der Übertragungs- oder Teilnehmeranschlußbaugruppe und über diese wiederm an die Meßwiderstände Rm in der Sendeleitung SL1 und in der Empfangsleitung EL1 angeschaltet ist. Die im oberen Teil von Fig. 2 angeordnete Stromversorgung SV für die Operationsverstärker OP1 und OP2 in der Eingangsschaltung ES, die in an sich bekannter Weise aufgebaut ist, enthält im wesentlichen den Wandler W sowie weitere hier nicht näher beschriebene Schaltungselemente. Die an dem in der Sendeleitung SL1 liegenden Widerstand Rm abfallende Spannung wird im Beispiel von Fig. 2 über die Schaltarme S1 und S2 zum einen dem nicht invertierenden Eingang 2 und zum anderen über das RC-Glied dem invertierenden Eingang 3 des Operationsverstärkers OP1 zugeführt. Am nichtinvertierenden Eingang 2 des Operationsverstärkers OP1 liegt auch des Nullpotential der Vorsorgungsspannung. Somit stellt sich am Verbindungspunkt von R1 und C1 eine Bezugsspannung ein, die stets positiv ist, wenn der Widerstand Rm von einem spoppolaren Strom durchflossen wird, die stets negativ ist, wenn ein startpolarer Strom durch den Widerstand Rm fließt und die O V ist, wenn bei Einfachstrombetrieb der startpolare Zustand auf der Telegrafierader auftritt und diese daher stromlos ist. Eine positive Bezugsspannung am Verbindungspunkt von C1 und R1 bewirkt, daß am Ausgang 5 des Operationsverstärkers OP1 eine verstärke negative Spannung entsteht. Dadurch fließt ein Strom durch die Diode des Optokopplers OK1, der dessen Ausgangstransistor durchlässig steuert. Ist die Bezugsspannung am Verbindungspunkt von C1 und R1 negativ oder O V, so liegen am Ausgang 5 des Operationsverstärkers OP1 ebenfalls O V und der Ausgangstransistor des Optokopplers OK1 bleibt gesperrt. Die beschriebenen Vorgänge gelten in gleicher Weise auch für die Arbeitsweise des Operationsverstärkers OP2, dem die am Widerstand Rm in der Empfangsleitung EL1 abfallende Spannung über die Schaltarme S3 und S4 zugeführt wird. In diesem Falle wird der Optokoppler OK2 derart gesteuert, daß dessen Ausgangstransistor bei Stoppolarität auf der Empfangsleitung EL1 leitend und bei Startpolarität auf der Empfangsleitung EL1 gesperrt ist. Die dem Eingang 3 jedes Operationsverstärkers OP1 und OP2 vorgeschalteten Kondensatoren C1 und C2 wirken als Differenzierglieder, die es ermögliche, auch bei stark verschliffenen Impulsflanken die Schritteinsätze so früh zu erkennen, daß praktisch keine Eigenverzerrung entsteht. Die den Gegenkopplungswiderständen R3 und R4 jeweils parallel geschalteten Kondensatoren C3 und C4 wirken als Integrierglieder, die eine verminderte Emfindlichkeit der Operationsverstärker OP1 und OP2 gegenüber negativen Störimpulsen am Eingang der Eingabeschaltung ES bewirken. Die Dioden D1 und D2 bzw. D3 und D4 dienen zur Begrenzung der Eingangsspannung der Operationsverstärker OP1 und OP2. Die Ausgangssignale der Optokoppler OK1 und OK2 stehen an den Schaltungspunkten A und B zur Verfügung.

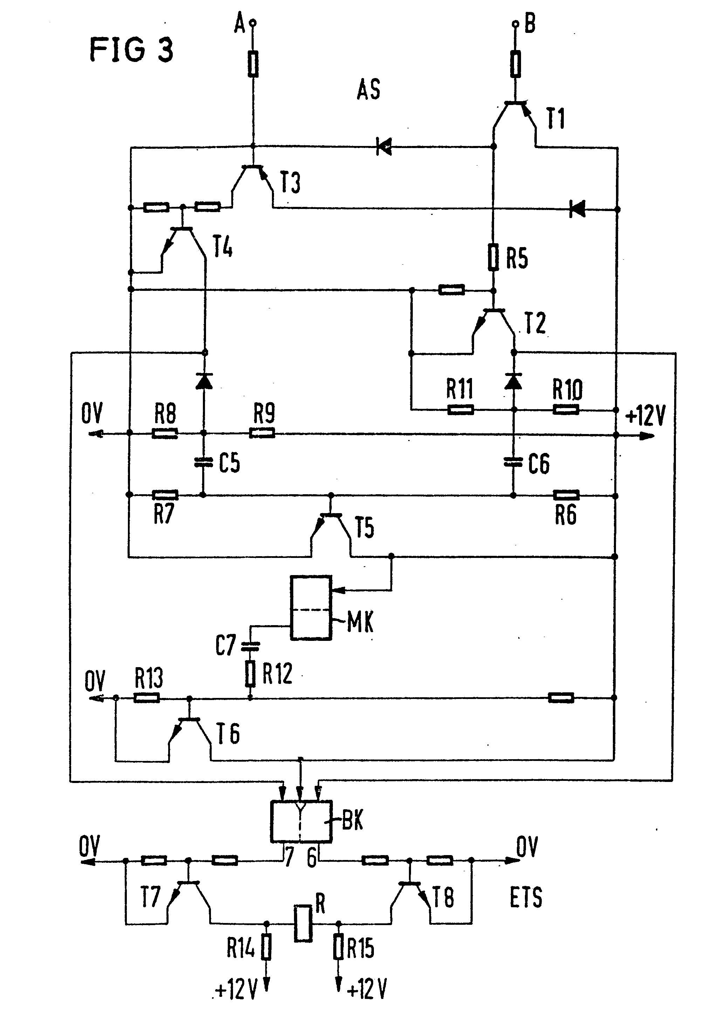

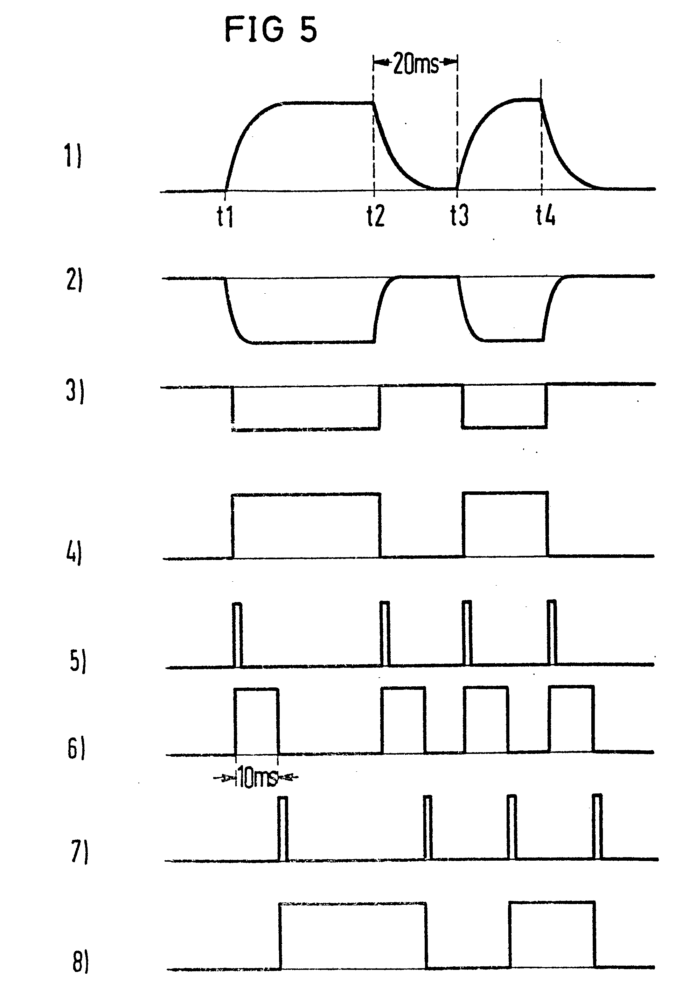

Den Aufbau der Ausgangsschaltung AS zeigt Fig. 3. Bei der Beschreibung der Wirkungsweise wird zugleich auch auf das Spannungs- und Impulsdiagramm für Einfachstrombetrieb in Fig. 5 bezug genommen. Es wird zunächst der Zustand der Schaltung beschrieben, der während des Ruhezustandes auf den Telegrafieleitungen besteht. Dieser ist durch Startpolarität sowohl auf der Sendeals auch auf der Empfangsleitung gekennzeichnet. Wie anhang von Fig. 2 erklärt wurde, sind dabei die Ausgangstransistoren der Optokoppler OK1 und OK2 gesperrt. In der Ausganschaltung AS sind damit über die Schaltungspunkte A und B die Transistoren T1 und T2 gesperrt, während die Transistoren T3, T4 und T5 leitend sind. Die bistabile Kippstufe BK befindet sich in der den startpolaren Zustand auf der Telegrafieleitung kennzeichnenden Lage. Der Kondensator C5 ist auf den durch den Spannungsteiler aus den Widerständen R6 und R7 bestimmten Spannungswert über den leitenden Transistor T4 aufgeladen. Der Kondensator C6 is infolge des gesperrten Transistors T2 auf einen Spannungswert aufgeladen, der durch die aus den Widerständen R6 und R7 sowie aus den Widerständen R10 und R11 bestehenden Spannungsteilerschaltungen bestimmt ist.

Nach erfolgter Verbindungsherstellung nehmen die Sendeung die Empfangsleitung den stoppolaren Zustand ein (Zeitpunkt t1 in Zeile 1, Fig. 5), Wie anhand von Fig. 2 beschrieben wurde, geben die Ausgänge der beiden Operationsverstärker OP1 und OP2 in diesem Falle eine negative Spannung ab (Zeile 2, Fig. 5) und die Ausgangstransistoren der beiden Optokoppler OK1 und OK2 werden in den leitenden Zustand gesteuert (Zeile 3, Fig. 5). Dadurch wird über den Schaltungspunkt B der Transistor T1 in der Ausgangschaltung AS leitend gesteuert. Über den Widerstand R5 wird nunmehr auch der Transistor T2 leitend. Die Transistoren T3 und T4 werden gesperrt. Über den leitenden Transistor T2 liegt jetzt der Kondensator C6 an 0 V lädt sich um. Der Transistor T5 wird während dieser Umladung über den Spannungsteiler mit den Widerständen R6 und R7 kurzzeitig gesperrt und gibt einen positiven Trigger-impuls an den Eingang der monostabilen Kippstufe MK ab (Zeile 5, Fig. 5). Zugleich wird der Kondensator C5 über die Spannungsteilerwiderstände R8 und R9 bzw. R6 und R7 wieder Aufgeladen. Der im Vorhergehenden beschriebene Schaltungsteil entspricht dem früher erwähnten Differenzierglied DG1. Die monostabile Kippstufe MK gibt nach Auslösung durch den Triggerimpuls einen Rechteckimpuls einstellbarer Länge ab. Die Länge des Rechteckimpulses ist von der Telegrafiergeschwindigkeit abhängig und kann beispielsweise auf die Telegrafiergeschwindigkeit von 50, 75 oder 100 Bd eingestellt sein. Im Ausführungsbeispiel beträgt die Länge des Rechteckimpulses 10 ms (Zeile 6, Fig. 5). Über die der monostabilen Kippstufe MK nachgeschaltete Differenzierschaltung DG2, die aus dem Kondensator C7, dem Widerstand R12, dem Transistor T6 und dem Widerstand R13 besteht, wird mit der negativen Flanke des Rechteckimpulses ein positiver Triggerimpuls erzeugt und an den Takteingang der bistabilen Kippstufe BK übertragen (Zeile 7, Fig. 5). Die bistabile Kippstuffe BK übernimmt dadurch den Schaltzustand der Transistoren T2 bzw. T4, die jeweils der auf der Telegrafierader herschenden Polarität entsprechen. Die bistabile Kippstufe BK ist als sogenantte Master-Slave-Kippstufe ausgebildet, so daß an ihrem Ausgang 6 bzw. 7 ein Ausgangssignal zur Verfügung steht das dem über die Telegrafieleitung übertragenen Zeichen entspricht und gegenüber diesem mit einer halben Schrittlänge verzögert ist. Die Auswertung des Ausgangssignals der bestabilen Kippstufe BK kann dann durch ein elektronisches Relais ETS erfolgen. Dabei ist im betrachteten Falle infolge von Stoppolarität auf der Telegrafierleitung der Transistor T2 leitend, so daß über den Äusgang 6 der bistabilen Kippstufe BK der Relaisteil R des elektronischen Relais ETS stoppolar erregt ist (+12 V, R14, R, T8, 0 V; Zeile 8, Fig. 5). Mit einem Wechsel der Polarität auf der Telegrafierleitung von Stoppolarität auf Startpolarität (Zeitpunkt t2 in Zeile 1, Fig. 5) sinkt, wie anhand von Fig. 2 beschrieben wurde, die Spannung am Ausgang der Operationsverstärker OP1 und OP2 auf den Wert 0 V ab (Zeile 2, Fig. 5), was zur Sperrung der Ausgangstransistoren der Optokoppler OK1 und OK2 führt (Zeile 3, Fig. 5). Über den Schaltungspunkt B wird dadurch der Transistor T1 gesperrt (Zeile 4, Fig. 5), während die Transistoren T3 und T4 leitend gesteuert werden. Dadurch werden die Kondensatoren C5 und C6 wieder in den Ladezustand gebracht, der dem bei Ruhezustand auf der Telegrafieleitung entspricht. Während der Umladung des Kondensators C5 wird der Transistor T5 kurzzeitig gesperrt und gibt in der beschriebenen Weise wieder einen positiven Triggerimpuls an die monostabile Kippstufe MK ab (Zeile 5, Fig. 5). Der von der monostabilen Kippstufe MK abgegebene Rechteckimpuls (Zeile 6, Fig. 5) führt in der ebenfalls bereits beschriebenen Weise zur Abgabe eines positiven Triggerimpulses (Zeile 7, Fig. 5), der an den Takteingang der bistabilen Kippstufe BK übertragen wird und diese nunmehr in die durch den leitenden Transistor T4 gekennzeichnete Lage umsteuert. Über den Ausgang 7 der bistabilen Kippstufe BK wird der Relaisteil R des elektronischen Relais ETS entsprechend der Startpolarität auf der Telegrafieleitung umgesteuert (+12 V, R15, R, T7, 0 V; Zeile 8 in Fig. 5). Diese Vorgänge wiederholen sich mit jedem Polaritätswechsel auf der Telegrafieleitung. Es wird somit jede ansteigende und jede abfallende Flanke eines Telegrafiezeichens differenziert und als Auslöseimpuls an den Eingang der integrierten monostabilen Kippstufe gelegt. Die Polarität der Eingangsschaltung wird somit jeweils mit der Verzögerung von einer halben Schrittlänge an das elektronische Relais ETS übertragen. Die durch Leitungseinflüsse verursachten Einschwingvorgänge zu Beginn jedes Zeichenschrittes werden eliminiert.

Da die Empfangsschaltung wahlweise an beliebig Telegrafiestromkreise anschaltbar ist und eine An- oder Abschaltung unterbrechungsfrei erfolgt, sowie dabei keine zusätzlichen Verzerrungen entstehen, kann die Empfangsschaltung mit Vorteil in sogenannten Mitleseeinrichtungen verwendet werden. Dazu ist in Ausgestaltung der Erfindung eine Verbindungsüberwachungsschaltung vorgesehen, die über das der bistabilen Kippstufe nachgeschaltete elektronische Relais steuerbar ist. Die Verbindungsüberwachungsschaltung hat dabei im wesentlichen die Aufgabe, den durch Stoppolarität auf beiden Telegrafieleitungen während einer vorbestimmten Zeitdauer gekennzeichneten Schreibzustand und den durch Startpolarität auf beiden Telegrafierleitungen während einer vorgegebenen zweiten Zeitdauer gekennzeichneten Auslösezustand zu erkennen und zu bewerten. Über zusätzliche Steuerschaltmittel ist damit erreichbar, nach Erkennen des Schreibsustandes die Polarität auf einer zu einer Mitlesemaschine führenden Leitung umzupolen und die Mitlesemaschine einzuschalten bzw. nach Erkennen des Auslösezustandes den ursprünglichen Zustand wider herzustellen, d.h. die Mitlesemaschine wieder abzuschalten Während des Schreibzustandes werden die Zeichenschritte auf der betrachteten Telegrafierleitung in der Mitlesemaschine aufgezeichnet, Die Verbindungsüberwachungsschaltung enthält dazu im wesentlichen Schalttransistoren und zeitbestimmende Schaltglieder für eine Ansprech- und eine Abschaltezeit. Eine als Verbindungsüberwachungsschaltung geeignete Schaltung ist z.B. in der DE—OS 2 438 470 beschrieben.

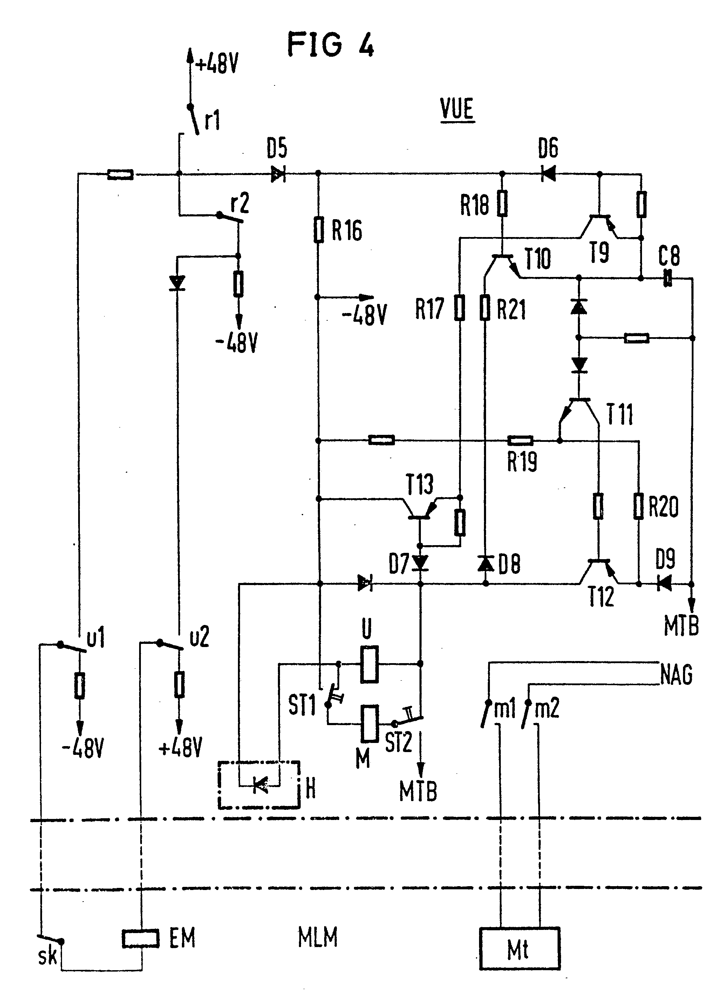

Einzelheiten dieser Ausgestaltung werden anhand eines in Fig. 4 dargestellten Ausführungsbeispiels beschrieben. Im Ruhezustand, d.h. bei Startpolarität auf mindestens einer der Telegrafierleitungen, befinden sich die Kontakte r1 und r 2 des elektronischen Relais ETS entsprechend der startpolaren Lage der bistabilen Kippstufe BK in der gezeichneten Lage. In diesem Falle sind über die Diode D6 die Transistoren T9 und T13 leitend und der Kondensator C8 wird aufgeladen (MTB, C8, T9, R17, T13, —48 V). Die Transistoren T11 und T12 sind gesperrt, so daß die am Spannungsteilerpunkt der Widerstände R19 und R20 liegende Spannung positiver ist als die am Kondensator C8 liegende Spannung. Die über den Transistor T12 schaltbaren Steuerschaltmittel, im Beispiel die Relais U und M, sind in diesem Falle nicht erregt, so daß über die Kontakte u1 und u2 eine dem Ruhezustand entsprechende Polarität auf der zur Mitlesemaschine MLM führenden Leitung herrscht. Mit dem Eintreffen eines stoppolaren Impulses, durch den die Relaiskontakte r1 und r2 umgesteuert werden, wird der Transistor T10 leitend und der Transistor T9 gesperrt. Für den Kondensator C8 besteht nun ein Umladestromkreis (MTB, C8 T10, R18, D5, r1, +48 V). Die Zeitdauer dieser Umladung ist durch die Dimensionierung des Widerstandes R18 und des Kondensators C8 sowie durch die Dimensionierung der Spannungsteilerschaltung R19 und R20 bestimmt. Diese Zeitdauer wird im folgenden als Ansprechzeit bezeichnet. Ist der stoppolare Impuls kürzer als die Ansprechzeit, d.h. trifft noch vor Ablauf der Ansprechzeit erneut ein startpolarer Impuls ein, so wird erneut der Transistor T9 leitend und der Transistor T10 gesperrt, so daß die Spannung am Kondensator C8 noch vor Erreichen des am Teilerpunkt der Widerstände R19 und R20 eingestellten Spannungswertes umgeladen wird. Dabei wird der Kondensator C8 zunächst in einen niederohmigen Stromkreis eingeschaltet und schnell entladen und dann erneut aufgeladen (MTB, C8, T9, D6, R16, —48 V). Die Transistoren T11 und T12 bleiben während dieser Umladungsvorgänge im gesperrten Zustand.

Als Ansprechzeit ist für das Ausführungsbeispiel eine Zeitdauer von 65 ms vorgesehen. Mit dem Eintreffen eines positiven Impulses, der länger als die Ansprechzeit dauert, werden nach Ablauf der Ansprechzeit die Transistoren T11 und T12 leitend gesteuert, so daß über die Diode D7 die Transistoren T13 und T9 gesperrt werden. Über die Diode D8 und den Widerstand R21 wird der Transistor T10 leitend, so daß der Kondensator C8 nunmehr mit einer sehr kleinen Zeitkonstante, die durch den Widerstand R21 und den Kondensator C8 bestimmt ist, sehr schnell entladen und anschließend aufgeladen wird (MTB, C8, T10, R18, D5, r1, +48 V). In einem über eine Anzeigediode H führenden Stromzweig werden die Relais U und M eingeschaltet (+MTB, D9, T12, U/ST2, M, ST1/H, –48 V).

Durch Umschaltung der Kontakte u1 und U2 wird die zur Mitlesemaschine MLM führende Leitung umgepolt, während über die Kontakte m1 und m2 der Stromkreis für den Motor Mt in der Mitlesemaschine MLM eingeschaltet wird. Die Übertragung der Zeichen an die Mitlesemaschine MLM im Schreibzustand geschieht über den Kontakt r2 des elektronischen Relais ETS. Nach Herstellung des Schreibzustandes ist der Kondensator C8 über den Kontakt r1 vollständig aufgeladen (MTB, C8, T10, R18 D5, r1, +48 V). Treffen während des Schreibzustandes startpolare Zeichen ein, so werden, wie beschrieben wurde, die Kontakte r1 und r2 des elektronischen Relais ETS umgesteuert, was bedeutet, daß sich der Kondensator C8 jeweils schnell über den dann leitenden Transistor T9 entlädt, wobei die Zeitkonstante für diese Entladung durch den Wert des Widerstandes R17 und des Kondensators C8 bestimmt ist. Nach dem Ladungsausgleicy besteht ein Aufladestromkreis für den Kondensator C8, für den eine Zeitkonstante gilt, die durch den Wert des Kondensators C8 und des Widerstandes R16 bestimmt ist. Trifft während dieser Aufladung ein stoppolarer Impuls ein, noch eine die Ladespannung am Kondensator C8 kleiner ist als die am Teilerpunkt der Widerstände R19 und R20 bestehende Spannung, so bleiben die Transistoren T11 und T12 leitend und die Relais U und M ändern ihre Lage nicht. In diesem Falle wird den Kondensator C8 erneut sehr schnell entladen. Die hier erwähnte durch den Wert des Widerstandes R16 und des Kondensators C8 bestimmte Zeitkonstante bestimmt die Abschaltverzögerung, d.h. die Abschaltzeit. Während des normalen Schreibzustandes treffen startpolare Impulse ein, die in keinem Falle größer sind als diese Abschaltzeit. Während des Schreibzustandes werden im Rhythmus der auf der betrachteten Telegrafieleitung übertragenen Telegrafiezeichen die Kontakte r1 und r2 betätigt. Über den Kontakt r2 wird die Leitung zur Mitlesemaschine MLM jeweils unterbrochen und im Empfangsmagnet EM der Mitlesemaschine MLM werden somit die übertragenen Zeichenschritte mitgeschrieben.

Trifft ein startpolarer Impuls ein, dessen Dauer größer ist als die erwähnte Abschaltezeit, so werden die Transistoren T11 und T12 gesperrt, wodurch die Relaid U und M abfallen und das Anzeigeelement H erlischt. Die Transistoren T9 und T13 werden leitend, so daß der Kondensator C8 erneut sehr schnell umgeladen wird Damit steht die ·volle Ansprechzeit wieder zur Verfügung. Die Verbindungsüberwachungsschaltung VUE befindet sich damit wieder im eingangs beschriebenen Ruhezustand.

Das in Fig. 4 dargestellte Ausführungsbeispiel enthält neben dem die Umpolung der Leitung bewirkenden Relais U noch das Relais M zur Ein- und Auschaltung des in der Mitlesemaschine MLM angeordneten Motors Mt. Die beiden Kontakte ST1 und ST2 können, wie in Fig. 4 dargestellt ist, auch als Schalter ausgebildet sein, über die ein Motorschaltrelais in der Mitlesemaschine MLM dauernd erregt ist, wenn der an die Netzsteckdose NAG gelegte Verbraucher, beispielsweise ein Fernschaltgerät oder eine Fernschreibmaschine mit mechanischem Fernschalter, eine eigene Netzeinschaltung besitzt.

Das Steuerrelais U polt die Zweidraht-Telegrafieleitung zur Mitlesemaschine MLM wie bei einem Ortsteilnehmeranschluß um. Dadurch ergibt sich die Möglichkeit, die Mitlesemaschine MLM über eine Anschlußleitung und ein Fernschaltgerät einzuschalten. Wie vorher erwähnt, kann dabei das Motorschaltrelais M wahlweise von der Mitleseeinrichtung MLE aus anschaltbar sein oder es kann, bei betätigtem Schalter ST1 und ST2, ständig eingeschaltet sein. Die Mitlesemaschine MLM kann aber auch mit einem mechanischen Fernschalter betrieben werden. In diesem Falle bewirkt der Übergang vom Ruhein den Schreibzustand eine Umpolung der Leitung und damit die Motoreinschaltung der Mitlesemaschine MLM.

Im Ausführungsbeispiel wurde von einer Ansprechzeit von 65 ms und von einer Abschaltezeit von 650 ms ausgegangen. Selbstverständlich sind entsprechend anderen Telegrafiergeschwindigkeiten und anderen Signalisierungsvorschriften auch andere Werte für die Einschalte- und Abschaltzeit einstellbar.

## Patentansprüche

1. Schaltungsanordnung zum Empfang von Einfachstrom- und Doppelstrom-Telegrafiezeichen mit ein Schwellwertverhalten aufweisenden Verstärkerelementen, die die an einem in einer Telegrafieleitung enthaltenen Widerstand (Rm) abfallende Spannung bewerten, dadurch gekennzeichnet, daß für in einer Mehrzahl vorgesehene Telegrafieleitungen (L) die hinsichtlich der Übertragung von Telegrafiezeichen entweder als Sendeleitung (SL1) oder als Empfangsleitung (EL1) ausgenutzt sind, zwei gesonderte Verstärkerelemente (OP1, OP2) vorgesehen sind, die mit Signaleigängen (3 in Fig. 2) jeweils über ein Differenzierglied (C1; C2) an jeweils in einer Empfangsleitung (EL1) bzw. in einer Sendeleitung (SL1) liegenden Widerständen (Rm) anschaltbar sind, daß die beiden Verstärkerelemente (OP1, OP2) mit ihren Stromversorgungsanschlüssen jeweils an einer eigenen, galvanisch von den Telegrafieleitungen (L) getrennten Stromversorgung (W bzw. S, V) angeschlossen sind, daß die beiden Verstärkerelemente (OP1, OP2) mit ihren Signalausgängen (5 in Fig. 2) zum einen jeweils über ein Integrationsglied (C3; C4) mit ihrem jeweiligen Signaleingang rückgekoppelt sind und zum anderen jeweils an einem Signaleingang (A; B) einer ersten Differenzierschaltung (DG1) angeschlossen sind, daß der ersten Differenzierschaltung (DG1) eine monostabile Kippstufe (MK) nachgeschaltet ist, die ausgangsseitig über eine zweite Differenzierschaltung (DG2) am Takteingang einer bistabilen Kippstufe (BK) angeschlossen ist, und daß die von ihrem Ausgang (6, 7 in Fig. 3) den jeweils empfangenen Telegrafiezeichen entsprechende Telegrafiezeichen abgebende bistabile Kippstufe (BK) mit ihren Datensignaleingängen an Schaltungspunkten angeschlossen ist, die den Ausgangssignalen der Verstärkerelemente (OP1, OP2) entsprechende Signale führen.

2. Schaltungsanordnung nach Anspruch 1, dadurch gekennzeichnet, daß die Verstärkerelemente (OP1, OP2) Operationsverstärker sind, die mit ihren invertierenden Eingängen (3 in Fig. 2) an der jeweiligen Telegrafieleitung (L) anschaltbar sind.

3. Schaltungsanordnung nach Anspruch 1, dadurch gekennzeichnet, daß die Kippzeit der monostabilen Kippstufe (MK) der halben Schrittdauer eines über die Telegrafieleitung (SL, DL) übertragenen Zeichenschrittes entspricht, daß der Ausgang der monostabilen Kippstufe (MK) mit dem Takteingang der bistabilen Kippstufe (BK) über die zweite Differenzierschaltung (DG2) verbunden ist und jeweils ein Vorbereitungseingang der bistabilen Kippstufe (BK) an jeweils einen durch das Ausgangssignal der Verstärkerelemente (OP1, OP2) steuerbaren Transistors (T2, T4) in der ersten Differenzierschaltung (DG1) angeschaltet ist und die bistabile Kippstufe (BK) mit jedem in der zweiten Differenzierschaltung (DG2) gebildeten Triggerimpuls entsprechend dem Zustand des betreffenden Transistors (T2 oder T4) umsteuerbar ist.

4. Schaltungsanordnung nach einem der Ansprüche 1 bis 3, dadurch gekennzeichnet, daß zwischen dem Ausgang der Verstärkerelemente (OP1, OP2) und der ersten Differenzierschaltung (DG1) Übertragungselemente (OK1, OK2) mit galvanischer Trennung zwischen Eingang und Ausgang vorgesehen sind.

5. Schaltungsanordnung nach Anspruch 4, dadurch gekennzeichnet, daß ein an die Ausgänge (6, 7) der bistabilen Kippstufe (BK) angeschaltetes elektronisches Relais (ETS) vorgesehen ist, das entsprechend der Lage der bistabilen Kippstufe (BK) startoder stoppolar erregbar ist.

6. Schaltungsanordnung nach Anspruch 5, dadurch gekennzeichnet, daß zur Bewertung der Ausgangssignale des elektronischen Relais (ETS) eine an sich bekannte Verbindungsüberwachungsschaltung vorgesehen ist, die über Kontakte (r1, r2) des elektronischen Relais (ETS) steuerbar ist und über die unter Steuerung zeitabhängiger Schaltmittel (C8, R18; C8, R16) steuerschaltmittel (U, M) ein- und ausschaltbar sind, daß den Steuerschaltmitteln (U, M) jeweils Schaltelemente (u1, u2; m1, m2)

zugeordnet sind, über die eine Anschlußleitung für eine Mitlesemaschine (MLM) umgepolt (+48 V, r1, u1, sk, EM u2, −48 V) und der Motor (Mt) der Mitlesemaschine einschaltbar ist, und daß der Empfangsmagnet (EM) der Mitlesemaschine (MLM) durch die Betätigung eines Kontaktes (r1) des elektronischen Relais (ETS) steuerbar ist.

7. Schaltungsanordnung nach Anspruch 6, dadurch gekennzeichnet, daß im Erregungskreis für das zur Motoreinschaltung vorgesehene Steuerschaltmittel (M) ein Schalter (ST1, ST2) vorgesehen ist, über den eine ständige Motoreinschaltung herstellbar ist.

8. Schaltungsanordnung nach Anspruch 6, dadurch gekennzeichnet, daß die Mitlesemaschine (MLM) direkt an die Verbindungsüberwachungsschaltung (VUE) angeschlossen ist.

9. Schaltungsanordnung nach Anspruch 6, dadurch gekennzeichnet, daß die Mitlesemaschine (MLM) über eine Anschlußleitung an die Verbindungsüberwachungsschaltung die (VUE) angeschaltet ist, und daß die Bewertung der Umpolung durch ein der Mitlesemaschine (MLM) zugeordnetes Fernschaltgerät erfolgt.

**Revendications**

1. Circuit de réception de signaux télégraphiques à simple courant et à double courant comportant des éléments amplificateurs possédant un comportement à valeur de seuil et qui évaluent la tension chutant aux bornes d'une résistance (Rm) contenue dans une ligne télégraphique, caractérisé en ce que pour des lignes télégraphiques (L), qui sont prévues en un grand nombre et qui sont utilisées, en ce qui concerne la transmission de signaux télégraphiques, soit comme ligne d'émission (SL1), soit comme ligne de réception (EL1), il est prévu deux éléments amplificateurs distincts (OP1, OP2) qui peuvent être branchés, par des entrées de signaux (3 dans la figure 2), respectivement par l'intermédiaire d'un organe différenciateur (C1; C2) à des résistances (Rm) situées respectivement dans une ligne de réception (EL1) ou dans une ligne d'émission (SL1), que les deux éléments amplificateurs (OP1, OP2) sont reliés respectivement à une alimentation en courant (W ou S, V) particulière, séparée galvaniquement des lignes télégraphiques (L), que les sorties des signaux (5 dans la figure 2) des deux éléments amplificateurs (OP1, OP2) sont d'une part accouplées par réaction respectivement par l'intermédiaire d'un organe d'intégration (C3; C4) à leur entrée respective des signaux et d'autre part sont raccordées respectivement à une entrée des signaux (A; B) d'un premier circuit différenciateur (DG1), qu'en série et en aval du premier circuit différenciateur (DG1) est branché un étage à bascule monostable (MK) qui du côté sortie, est relié par l'intermédiaire d'un second circuit différenciateur (DG2), à l'entrée de cadence d'un étage à bascule bistable (BK), et que l'étage à bascule bistable (BK), qui délivre par sa sortie (6, 7 dans la figure 3), des signaux télégraphiques correspondant aux signaux télégraphiques respectivement reçus, est relié par ses entrées di signaux de données à des points du circuit qui conduisent des signaux correspondant aux signaux de sortie des éléments amplificateurs (OP1, OP2).

2. Circuit selon la revendication 1, caractérisé en ce que les éléments amplificateurs (OP1, OP2) sont des amplificateurs opérationnels qui peuvent être raccordés, par leurs entrées inverseuses (3 dans la figure 2) à la ligne télégraphique concernée (L).

3. Circuit selon la revendication 1, caractérisé en ce que la durée de basculement de l'étage à bascule monostable (MK) correspond à la demi-durée d'un intervalle significatif transmis par l'intermédiaire de la ligne télégraphique (SL, DL), que la sortie de l'étage à bascule monostable (MK) est reliée à l'entrée de cadence de l'étage à bascule bistable (BK) par l'intermédiaire du second circuit différenciateur (DG2) et que respectivement une entrée de préparation de l'étage à bascule bistable (BK) est raccordée respectivement à un transistor (T2, T4) pouvant être commandé par les signaux de sortie des éléments amplificateurs (OP1, OP2) et situé dans le premier circuit différenciateur (DG1) alors que la commande de l'étage à bascule bistable (BK) peut être inversée avec chaque impulsion de déclenchement, formée dans le second circuit différenciateur (DG2), conformément à l'état du transistor considéré (T2 ou T4).

4. Circuit selon l'une des revendications 1 à 3, caractérisé en ce que des organes de transmission (OK1, OK2) présentant une séparation galvanique entre l'entrée et la sortie sont prévus entre la sortie des éléments amplificateurs (OP1, OP2) et le premier circuit différenciateur (DG1).

5. Circuit selon la revendication 4, caractérisé en ce qu'il est prévu un relais électronique (ETS) relié aux sorties (6, 7) de l'étage à bascule bistable (BK) et qui peut être excité avec une polarité de mise en marche ou avec une polarité d'arrêt, en fonction de la position de l'étage à bascule bistable (BK).

6. Circuit selon la revendication 5, caractérisé en ce que pour l'évaluation des signaux de sortie du relais électronique (ETS) il est prévu un circuit de contrôle des liaisons, connu en soi, qui peut être commandé par l'intermédiaire de contact (r1, r2) du relais électronique (ETS) et par l'intermédiaire duquel des moyens de commande de commutation (U, M) peuvent être branchés et débranchés sous la commande de moyens de commutation dépendant du temps C8, R18; C8, R16), qu'aux moyens de commutation de commande (U, M) sont associés respectivement des organes de commutation (u1, u2; m1, m2), par l'intermédiaire desquels la polarité d'une ligne de branchement pour un appareil de lecture de contrôle (MLM) est inversée (+48 V, r1, u1, sk, EM u2, −48 V) et le moteur (Mt) de l'appareil de lecture de contrôle peut être branché, et que l'aimant de réception (EM) de l'appareil de lecteure de contrôle (MLM) peut être commandé par l'actionnement d'un contact (r1) du relais électronique (ETS).

7. Montage selon la revendication 6, caractérisé en ce que dans le circuit d'excitation pour le moyen de commutation de commande (M) prévu pour le branchement du moteur se trouve prévu un commutateur (ST1, ST2) par l'intermédiaire duquel un branchement permanent du moteur peut être établi.

8. Circuit selon la revendication 6, caractérisé en ce que l'appareil de lecture de contrôle (MLM) est raccordé directement au circuit (VUE) de contrôle des liaisons.

9. Circuit selon la revendication 6, caracterisé en ce que l'appareil de lecture de contrôle (MLM) est raccordé par l'intermédiaire d'une ligne de branchement au circuit (VUE) de contrôle des liaisons et que l'évaluation de l'inversion de polarité est réalisée au moyen d'un coffret de télécommande associé à l'appareil de lecture de contrôle (MLM).

**Claims**

1. Circuit arrangement for the reception of single-current and double current telegraphy signals comprising amplifier elements which possess threshold value characteristics and which evaluate the voltage occurring across a resistor (Rm) included in a telegraphic line, characterised in that telegraphic lines (L) provided in a plurality, which are used either as a transmitting line (SL1) or as a receiving line (EL1) with regard to the transmission of telegraphy signals, are provided with two separate amplifier elements (OP1, OP2) which can each be connected by signal inputs (3 in Fig. 2) via a differentiator element (C1; C2) to resistors (Rm) located in a receiving line (EL1) or, as the case may be, in a transmitting line (SL1), that the two amplifier elements (OP1, OP2) are each connected via their current supply terminals to a separate current supply (W or S.V.) D.C. isolated from the telegraphic lines (L), that at their signal outputs (5 in Fig. 2) the two amplifier elements are on the one hand feedback-connected via an integration element (C3; C4) to their own signal input and on the other hand are connected to a signal input (A:B) of a first differentiator circuit (DG1) that the first differentiator circuit (DG1) is followed by a monostable flip-flop (MK) which is connected at its output via a second differentiator circuit (DG2) to the clock pulse input of a bistable flip-flop (BK), and that the bistable flip-flop (BK) which from its output (6, 7 in Fig. 3) emits telegraphy signals corresponding to the received telegraphy signals is connected by its data signal inputs to circuit points which conduct signals corresponding to the output signals of the amplifier elements (OP1, OP2).

2. Circuit arrangement as claimed in claim 1, characterised in that the amplifier elements (OP1, OP2) consist of operational amplifiers which can be connected by their inverting inputs (3 in Fig. 2) to the relevant telegraphic line (L).

3. Circuit arrangement as claimed in claim 1, characterised in that the trigger time of the monostable flipflop (MK) corresponds to half the element duration of a character element transmitted via the telegraphic line (SL, DL), that the output of the monostable flip-flop (MK) is connected to the clock pulse input of the bistable flip-flop (BK) via the second differentiator circuit (DG2), and a preparation input of the bistable flip-flop (BK) is in each case connected to a transistor (T2, T4) which can be controlled by the output signal of the amplifier elements (OP1, OP2) and which is contained in the first differentiator circuit (DG1) and the bistable flip-flop (BK) may be reversed with every trigger pulse formed in the second differentiator circuit (DG2) in accordance with the state of the transistor in question (T2 or T4).

4. Circuit arrangement as claimed in one of the claims 1 to 3, characterised in that transmission elements (OK1, OK2) featuring D.C. isolation between input and output are arranged between the output of the amplifier elements (OP1, OP2) and the first differentiator circuit (DG1).

5. Circuit arrangement as claimed in claim 4, characterised in that an electronic relay (ETS) is provided which is connected to the outputs (6, 7) of the bistable flip-flop (BK) and which can be energised with start polarity or stop polarity in accordance with the position of the bistable flip-flop (BK).

6. Circuit arrangement as claimed in claim 5, characterised in that for the evaluation of the output signals of the electronic relay (ETS) a connection monitoring circuit known *per se* is provided which can be controlled via contacts (r1, r2) of the electronic relay (ETS) and via which, under the control of time-dependent switching means (C8, R18; C8, R16), control switching means (U, M) can be switched on and off, that each of the control switching means (U, M) are assigned switching elements (u1, u2; m1, m2) via which a connection line for control apparatus (MLM) can be reversed in polarity (+48 V, r1, u1, sk, EM, u2 —48 V) and the motor (Mt) of the control apparatus (MLM) can be switched on, and that the receiving magnet (EM) of the control apparatus (MLM) can be controlled by the actuation of a contact (r1) of the electronic relay (ETS).

7. Circuit arrangement as claimed in claim 6, characterised in that the energising circuit for the control switching means (M) provided for switching on the motor contains a switch (ST1, ST2) via which a permanent motor connection can be established.

8. Circuit arrangement as claimed in claim 6, characterised in that the control apparatus (MLM) is directly connected to the connection monitoring circuit (VUE).

9. Circuit arrangement as claimed in claim 6, characterised in that the control apparatus (MLM) is connected via a connection line to the connection monitoring circuit (VUE), and that the evaluation of the polarity reversal is effected by a remote switching device assigned to the control apparatus (MLM).

FIG 1

# FIG 2

FIG 3

# FIG 4

VUE

## FIG 5